(19) Europäisches Patentamt
European Patent Office
Office européen des brevets

(11) **EP 0 696 862 B1**

(12) **EUROPÄISCHE PATENTSCHRIFT**

(45) Veröffentlichungstag und Bekanntmachung des Hinweises auf die Patenterteilung:
**29.04.1998 Patentblatt 1998/18**

(51) Int Cl.⁶: **H04L 27/38**, H03D 1/22, H04L 27/227

(21) Anmeldenummer: **95112495.7**

(22) Anmeldetag: **09.08.1995**

(54) **Phasendetektor für die Steuerung der Rückgewinnung eines Trägersignals**

Phasedetector for control of carrier recovery

Comparateur de phase pour le réglage de la régénération de la porteuse

(84) Benannte Vertragsstaaten:
**AT CH DE FR GB IT LI NL**

(30) Priorität: **12.08.1994 DE 4428643**

(43) Veröffentlichungstag der Anmeldung:
**14.02.1996 Patentblatt 1996/07**

(73) Patentinhaber: **GRUNDIG Aktiengesellschaft 90762 Fürth (DE)**

(72) Erfinder: **Vanselow, Frank, Grundig E.M.V. D-90762 Fürth (DE)**

(56) Entgegenhaltungen:
**EP-A- 0 322 766          US-A- 4 466 109**

• **PATENT ABSTRACTS OF JAPAN vol. 011 no. 338 (E-553) ,5.November 1987 & JP-A-62 118660 (KOKUSAI DENSHIN DENWA CO LTD) 30.Mai 1987,**

**Beschreibung**

Die vorliegende Erfindung betrifft einen Phasendetektor für die Steuerung der Rückgewinnung eines Trägersignals zur Demodulation eines Modulationssignals mit unterdrücktem Trägersignal, mit den Merkmalen des Oberbegriffs von Patentanspruch 1.

Für die Demodulation eines mit komplexen Symbolen modulierten Trägersignals (z.B. PSK: Phase Shift Keying, QAM: Quadratur Amplituden Modulation) wird in den meisten Fällen - da in der Regel für eine fehlerfreie Demodulation keine Abweichung von Frequenz und Phase zwischen dem Trägersignal auf Sende- und Empfangsseite bestehen darf - ein spannungsgesteuerter Oszillator verwendet. Mit dem vom Oszillator erzeugten Trägersignal und einem dazu um 90° verschobenen Signal wird das empfangene Signal, bzw. ein davon abgeleitetes Zwischenfrequenzsignal, mittels Mischern in das Basisband umgesetzt und demoduliert.

Der zur Rückgewinnung des Trägersignals im Empfänger verwendete Oszillator wird mittels einer Regelspannung gesteuert, die aus dem Zf-Signal oder dem Basisbandsignal gewonnen wird. Zur Erzeugung der Regelspannung sind Fehlerdetektoren mit und ohne Rückkopplung bekannt und werden beispielsweise in "Digitale Modulationsverfahren" von R. Mäusel, 2. Aufl., 1988, Hüthig-Verlag Heidelberg, beschrieben. Die rückgekoppelten Fehlerdetektoren bieten dabei generell den Vorteil, daß die Regelgröße (hier: der Phasenfehler) sehr klein wird.

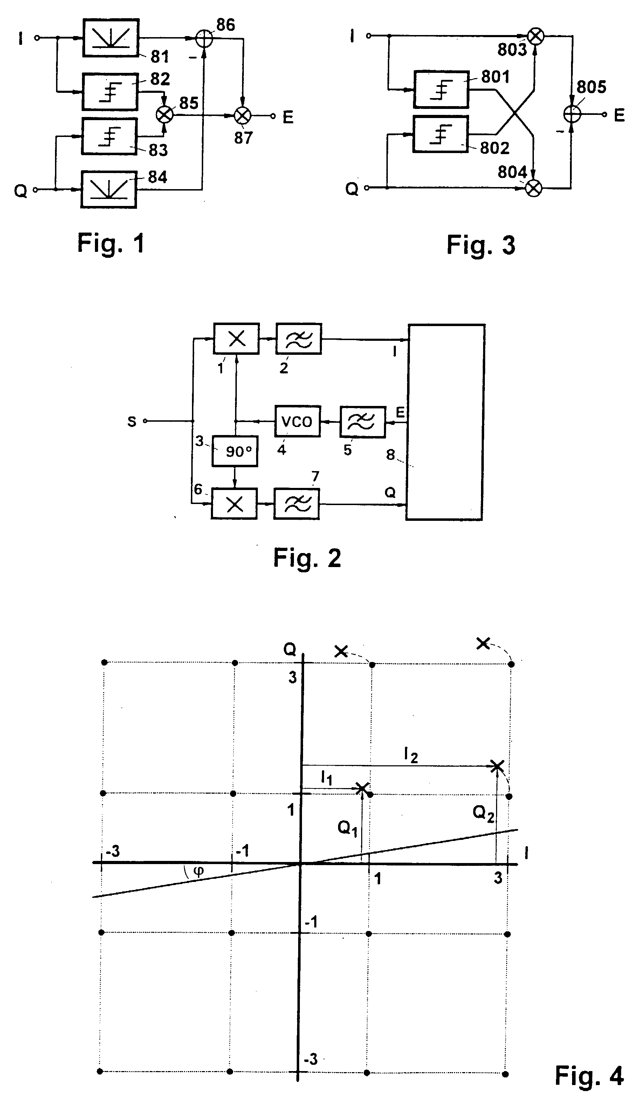

In Figur 2 ist der prinzipielle Aufbau eines Demodulators mit einem rückgekoppelten Phasendetektor dargestellt. Ein Modulationssignal S wird mittels zweier Mischer 1 und 6 demoduliert. Dazu wird am Mischer 1 das von einem spannungsgesteuerten Oszillator 4 erzeugte Trägersignal, und am Mischer 2 ein mittels eines Phasenschiebers 3 um 90° gegenüber dem Trägersignal versetztes Signal angelegt.

Nach einer Tiefpaßfilterung mittels der Filter 2 und 7 stehen das Inphasen- und Quadraturphasensignal I und Q zur weiteren Verarbeitung zur Verfügung. Aus Inphasen- und Quadraturphasensignal I und Q wird in einem Phasendetektor 8 ein Steuersignal E erzeugt, dessen Spannung, nach einer Tiefpaßfilterung mit dem Filter 5, den Oszillator 4 steuert.

Figur 3 stellt den Aufbau eines bekannten Phasendetektors, des sogenannten "Costas-Loop", dar. Mittels zweier Entscheider 801 und 802 werden die Signalwerte von Inphasen- und Quadraturphasensignal I und Q bestimmt und überkreuz mittels zweier Multiplizierer 803 und 804 mit dem Inphasen- bzw. Quadraturphasensignal I und Q multipliziert. Aus den Signalen der Ausgänge der Multiplizierer 803 und 804 wird mittels eines Subtrahierers 805 das Steuersignal E gebildet. Man unterscheidet zwischen "hartem" und "weichem" Costas-Loop. Beim "harten" Costas-Loop wird mittels der Entscheider 801 und 802 nur das Vorzeichen von Inphasen- und Quadraturphasensignal ermittelt, während beim "weichen" Costas-Loop neben dem Vorzeichen auch die Amplitudenwerte ermittelt werden. Dabei nehmen die Entscheider 801 und 802 eine Quantisierung der Amplitudenwerte vor. Den Amplitudenwerten werden die Werte zugewiesen, welche die einzelnen Signalwerte ohne Störeinwirkungen wie Rauschen oder Abweichung der Phase des rückgewonnenen Trägersignals aufweisen würden. In diesem Zusammenhang wird auf Figur 4 verwiesen, die ein Phasenzustandsdiagramm für eine sechzehnstufige Quadraturamplitudenmodulation (16-QAM) darstellt. Die durch die Entscheider festgelegten Sollwerte der Signalwerte sind durch Punkte dargestellt, die sich tatsächlich bei der Demodulation ergebenden I- und Q-Amplitudenwerte sind im ersten Quadranten durch Kreuze angedeutet. Die Abweichung der tatsächlichen Werte von den Sollwerten werden durch die dargestellte Phasenverschiebung $\varphi$ verursacht. Durch die Entscheider werden die jeweiligen Sollwerte der Amplituden ausgewählt, zu denen die ermittelten Amplitudenwerte (z.B. $I_1$ und $Q_1$) die geringste Abweichung aufweisen.

Für niederwertige Modulationsverfahren (z.B. QPSK) arbeitet der Phasendetektor nach Costas mit befriedigenden Ergebnissen, sollen jedoch Steuersignale für die Rückgewinnung des Trägersignals von höherwertigen Modulationssignalen (z.B. 16-QAM oder größer) zur Verfügung gestellt werden, ergeben sich Probleme, da der Costas-Loop dann eine sehr große Erfassungszeit aufweist. Die große Erfassungszeit ergibt sich u.a. weil die Kennlinie des Steuersignals des Phasendetektors nur für sehr geringe Phasenabweichungen linear ist. Unzulässige Nullstellen in der Kennlinie können sogar zu einem falschen Einrasten der Regelschleife führen.

Aufgabe der vorliegende Erfindung ist es deshalb, einen Phasendetektor für die Steuerung der Rückgewinnung eines Trägersignals zur Demodulation eines Modulationssignals mit unterdrücktem Trägersignal anzugeben, bei dem die geschilderten Probleme vermieden werden.

Erfindungsgemäß wird diese Aufgabe durch die Merkmale des Patentanspruchs 1 gelöst.

Der Vorteil der Erfindung liegt insbesondere darin, daß der erfindungsgemäße Phasendetektor durch die Gewichtung der sich ergebenden Fehlersignale mit den entschiedenen Amplitudenwerten wesentlich geringere Erfassungszeiten aufweist als bekannte Lösungen. Außerdem ist der Realisierungsaufwand des erfindungsgemäßen Phasendetektors sehr gering.

Weitere Vorteile der Erfindung ergeben sich aus den Unteransprüchen und der nachfolgenden Beschreibung und Erläuterung anhand von Figuren.

Es zeigen:

Figur 1 einen erfindungsgemäßen Phasendetektor,

Figur 2 den Aufbau eines Demodulators,

Figur 3 den Aufbau eines Phasendetektors nach Costas, und

Figur 4 ein Phasenzustandsdiagramm für eine 16-QAM.

Aus der Patentschrift US 4,466,109 ist ein Phasendetektor zur Steuerung der Rückgewinnung eines Trägersignals bei einem höherwertigen Modulationssignal (16-QAM) bekannt. Der bekannte Phasendetektor ist aber mehrstufig und sehr aufwendig und kompliziert aufgebaut. Er weist einen Vorzeichendetektor und einen Amplitudendetektor auf, deren Ausgangssignale einen Umschalter ansteuern, der wahlweise drei Paare von Inphasen- und Quadraturphasensignalen an den eigentlichen Phasendetektor, der von einem Costas-Loop gebildet wird, weiterleitet.

Der in Figur 1 dargestellte erfindungsgemäße Phasendetektor weist zwei Einrichtungen 81 und 84 zur Ableitung des Amplitudenbetrags der Inphasen- und Quadraturphasensignale I und Q auf. Von den Beträgen des Inphasensignals I I I werden die Beträge des Quadraturphasensignals I Q I mittels eines Subtrahierers 86 subtrahiert. Außerdem weist der Phasendetektor zwei Entscheider 82 und 83 auf, die wie oben beschrieben, die Vorzeichen und quantisierten Amplitudenwerte von Inphasen- und Quadraturphasensignal bestimmen. Die von den Entscheidern 82 und 83 bestimmten Werte werden mittels eines ersten Multiplizierers 85 multipliziert. Mittels eines zweiten Multiplizerers 87 werden die vom ersten Multiplizierer 85 und vom Subtrahierer 86 stammenden Signale multipliziert und bilden ein Steuersignal E.

Die Vorzeichen von Inphasen- und Quadraturphasensignal werden nachfolgend mit der sgn-Funktion dargestellt, die entschiedenen Amplitudenwerte als $I_q$ und $Q_q$. Für die sgn-Funktion gilt:

$$sgn(x) = \begin{cases} 1 & \text{für} \quad x > 0 \\ 0 & \text{für} \quad x = 0 \\ -1 & \text{für} \quad x < 0 \end{cases}$$

Das Steuersignal E ergibt sich somit aus folgender Gleichung:

$$E = (|I| - |Q|) \cdot I_q \cdot Q_q \cdot sgn(I) \cdot sgn(Q)$$

Im Gegensatz dazu ergibt sich das Steuersignal $E_C$ für den in Figur 3 dargestellten Costas-Loop als:

$$E_C = (|I| \cdot Q_q - |Q| \cdot I_q) \cdot sgn(I) \cdot sgn(Q)$$

Aus den Gleichungen für die Steuersignale E und

$E_C$ ist sofort ersichtlich, daß für den Fall der "harten" Entscheidung (die Entscheider bestimmen nur die Vorzeichen, der Betrag von $I_q$ und $Q_q$ ist also gleich eins) die Steuersignale des erfindungsgemäßen Phasendetektors und des Phasendetektors nach Costas gleich sind.

Für den Fall der "weichen" Entscheidung (die Entscheider bestimmen die Vorzeichen und die quantisierten Beträge der Amplitudenwerte, somit ergeben sich für das in Figur 4 dargestellte Beispiel Beträge von eins und drei für $I_q$ und $Q_q$) zeigt die Gleichung für das Steuersignal E des erfindungsgemäßen Phasendetektors, daß durch die Multiplikation der Differenz der Beträge von Inphasen- und Quadraturphasensignal I I I und I Q I mit den quantisierten Beträgen $I_q$ und $Q_q$ eine Gewichtung des Fehlersignals vorgenommen wird. Die Gewichtung wirkt selektiv und hebt große Amplituden an wohingegen kleine Amplituden abgesenkt werden, so daß keine Verschlechterung des Signal-Rauschabstands eintritt. Außerdem vergrößert sich durch die Gewichtung der lineare Bereich der Detektorkennlinie, unerlaubte Nullstellen werden vermieden.

Wie aus der Gleichung $E_C$ für den bekannten Phasendetektor nach Costas zu sehen ist, erfolgt bei diesem die oben beschriebene selektive Anhebung im Falle der "weichen" Entscheidung nicht, wodurch die beschriebenen unerlaubten Nullstellen und der geringe lineare Bereich der Kennlinie des Phasendetektors nach Kostas zu erklären sind.

Aus der beschriebenen Ausführungsform des erfindungsgemäßen Phasendetektors ergeben sich für den Fachmann in naheliegender Weise weitere Ausgestaltungsmöglichkeiten. Beispielsweise können die Entscheider statt der beschriebenen quantisierten Amplitudenbeträge die unqnatisierten Beträge der Amplituden bestimmen. Ebenso ist es offensichtlich, daß statt des erläuterten analogen Aufbaus ein digitaler Aufbau möglich ist.

**Patentansprüche**

1. Phasendetektor (8) für die Steuerung der Rückgewinnung eines Trägersignals zur Demodulation eines Modulationssignals (S) mit unterdrücktem Trägersignal, wobei der Phasendetektor ein Steuersignal (E) zur Steuerung eines Oszillators (4) aus dem Inphasen- und Quadraturphasensignal (I, Q) des Modulationssignals (S) ableitet,
**dadurch gekennzeichnet,**
daß der Phasendetektor (8) aufweist

- erste Einrichtungen (81, 84) zur Bildung des Amplitudenbetrags von Inphasen- und Quadraturphasensignal (I, Q),
- zweite Einrichtungen (82. 83) zur Bildung von Signalwerten, die den Vorzeichen von Inphasen- und Quadraturphasensignal (I, Q) entsprechen,

- einen ersten Multiplizierer (85) zur Multiplikation der von den zweiten Einrichtungen (82, 83) gebildeten Siganlwerte,
- einen Subtrahierer (86) zur Subtraktion der von den ersten Einrichtungen (81. 84) gebildeten Amplitudenbeträge,
- einen zweiten Multiplizierer (87), der durch Multiplikation der Ausgangssignale des ersten Multipliziers (85) und des Subtrahierers (86) das Steuersignal (E) bildet, und
- daß die zweiten Einrichtungen (82, 83) zusätzlich die Amplitudenwerte des Inphasen- und Quadraturphasensignals (I, Q) in quantisierter Form bilden und Vorzeichen sowie quantisierte Amplitudenwerte an den ersten Multiplizierer (85) weiterleiten.

## Claims

1. Phase detector (8) for controlling the recovery of a carrier signal for the demodulation of a modulation signal (S) having suppressed carrier signal, the phase detector deriving a control signal (E) for controlling an oscillator (4) from the in-phase and quadrature-phase signals (I, Q) of the modulation signal (S), characterized in that the phase detector (8) has

- first devices (81, 84) for forming the amplitude modulus of in-phase and quadrature-phase signals (I, Q),
- second devices (82, 83) for forming signal values which correspond to the sign of in-phase and quadrature-phase signals (I, Q),
- a first multiplier (85) for multiplying the signal values formed by the second devices (82, 83),
- a subtracter (86) for subtracting the amplitude moduli formed by the first devices (81, 84),
- a second multiplier (87) which forms the control signal (E) by multiplying the output signals of the first multiplier (85) and the subtracter (86), and
- in that the second devices (82, 83) additionally form the amplitude values of the in-phase and quadrature-phase signals (I, Q) in quantized form and pass sign and also quantized amplitude values to the first multiplier (85).

## Revendications

1. Détecteur de phase (2) pour la commande de la récupération d'un signal de porteuse pour la démodulation d'un signal de modulation (S) avec le signal de porteuse supprimé, le détecteur de phase déterminant un signal de commande (E) pour la commande d'un oscillateur (4) à partir d'un signal en phase et d'un signal en quadrature (I, Q) du signal de modulation (S), caractérisé en ce que le détecteur de phase (8) comprend

- des premiers dispositifs (81, 84) pour former la valeur absolue de l'amplitude du signal en phase et du signal en quadrature de phase (I, Q),
- des secondes dispositifs (82, 83) pour former des valeurs de signaux, qui correspondent aux signes du signal en phase et du signal en quadrature de phase (I, Q),
- un premier multiplicateur (85) pour multiplier les valeurs de signaux formées par les seconds dispositifs (82, 83),
- un soustracteur (86) pour soustraire les valeurs absolues d'amplitudes formées par les premiers dispositifs (81, 84),
- un second multiplicateur (87) qui forme le signal de commande (E), par multiplication des signaux de sortie du premier multiplicateur (85) et du soustracteur (86), et
- que les seconds dispositifs (82, 83) forment en outre les valeurs d'amplitude du signal en phase et du signal en quadrature de phase (I, Q) et retransmettent des signes ainsi que des valeurs d'amplitude quantifiées au premier multiplicateur (85).

**Fig. 1**

**Fig. 3**

**Fig. 2**

**Fig. 4**